# EUROPÄISCHE PATENTSCHRIFT

(11) **EP 1 761 959 B1**
(45) Veröffentlichungstag und Bekanntmachung des Hinweises auf die Patenterteilung: **24.10.2018**
(21) Anmeldenummer: 05753601.3
(22) Anmeldetag: 18.05.2005
(51) Int. Cl.: H01L 33/58, H01L 33/62, H01L 33/64, H01L 33/60

(54) **LEUCHTDIODENANORDNUNG**
LIGHT-EMITTING DIODE ASSEMBLY
DISPOSITIF A DIODE ELECTROLUMINESCENTE

(30) Priorität: 30.06.2004 DE 102004031686; 22.09.2004 DE 102004045947
(43) Veröffentlichungstag der Anmeldung: 14.03.2007
(60) Teilanmeldung: 11158098.1
(73) Patentinhaber: OSRAM Opto Semiconductors GmbH, 93055 Regensburg (DE)
(72) Erfinder: BOGNER, Georg, 93138 Lappersdorf (DE); GRÖTSCH, Stefan, 93077 Lengfeld/Bad Abbach (DE); WAITL, Günter, 93049 Regensburg (DE); WANNINGER, Mario, 93055 Harting (DE)
(74) Vertreter: Epping - Hermann - Fischer
(86) Internationale Anmeldenummer: PCT/DE2005/000904
(87) Internationale Veröffentlichungsnummer: WO 2006/002603

(56) Entgegenhaltungen:
- US-A1- 2003 201 451
- US-A1- 2004 070 337
- US-A1- 2004 211 970

## Beschreibung

Die Erfindung betrifft eine Leuchtdiodenanordnung.

Die Druckschrift US 6,657,375 B2 beschreibt eine Leuchtdiodenanordnung, die wenigstens eine Leuchtdiode aufweist, die Licht emittiert, das aus den Seitenflächen und der Oberfläche der Leuchtdiode austritt. Dabei wird das emittierte Licht durch Leuchtstoffe, die der primären Strahlung der Leuchtdiode ausgesetzt sind, teilweise oder vollständig in langwelligere Strahlung konvertiert. Der Leuchtdiodenchip ist in eine Ausnehmung des Gehäuses angeordnet. Die Wände des Gehäuses sind reflektierend ausgebildet, und die Ausnehmung ist mit einer Vergussmasse gefüllt, welche den Leuchtdiodenchip vollständig umhüllt. Die Leuchtstoffartikel zur Konvertierung des vom Leuchtdiodenchip abgegebenen Lichts sind dieser Vergussmasse beigemischt.

In den Druckschriften US 2003/0201451 A1, US 2004/0070337 A1, TW 595019 B, US 2004/0211970 A1 und WO 2004/053933 sind Licht emittierende Vorrichtungen gezeigt.

Es ist Aufgabe der vorliegenden Erfindung, eine Leuchtdiodenanordnung mit besonders hoher Lichtstrahlleistung anzugeben. Diese Aufgabe wird gelöst durch eine Leuchtdiodenanordnung nach Patentanspruch 1. Vorteilhafte Ausgestaltungen der Erfindung sind Gegenstand von Unteransprüchen.

Gemäß wenigstens einer Ausführungsform der Leuchtdiodenanordnung wird eine Leuchtdiodenanordnung angegeben, die bevorzugt wenigstens einen Leuchtdiodenchip aufweist. Bevorzugt weist der Leuchtdiodenchip eine Strahlungsauskoppelfläche auf, über die ein Großteil der im Leuchtdiodenchip erzeugten elektromagnetischen Strahlung austritt.

Bevorzugt tritt die Strahlung in Richtung einer Hauptabstrahlrichtung aus. Besonders bevorzugt tritt die im Leuchtdiodenchip erzeugte Strahlung ausschließlich über die Strahlungsauskoppelfläche aus. Dabei ist die Strahlungsauskoppelfläche bevorzugt durch eine der Hauptflächen des Leuchtdiodenchips gegeben. Die Seitenflächen des Leuchtdiodenchips, die quer zu den Hauptflächen verlaufen, sind bevorzugt strahlungsundurchlässig ausgestaltet. Dabei können diese Chipflächen beispielsweise strahlungsreflektierend oder strahlungsabsorbierend ausgestaltet sein.

Weiter weist die Leuchtdiodenanordnung bevorzugt ein Gehäuse auf, das den Leuchtdiodenchip seitlich umschließt. Das heißt, die Seitenflächen des Leuchtdiodenchips sind von dem Gehäuse umgeben. Die Seitenflächen verlaufen vorzugsweise senkrecht oder im wesentlichen senkrecht zur Strahlungsauskoppelfläche des Leuchtdiodenchips.

Die Leuchtdiodenanordnung weist weiterhin bevorzugt eine reflektive Optik auf. Die reflektive Optik ist vorzugsweise der Strahlungsauskoppelfläche in der Hauptabstrahlrichtung nachgeordnet. Das heißt, zumindest ein Teil der vom Leuchtdiodenchip emittierten Strahlung tritt auf die reflektive Optik auf und wird von dieser reflektiert.

Bevorzugt weist die Leuchtdiodenanordnung also einen Leuchtdiodenchip mit einer Strahlungsauskoppelfläche auf, über die ein Großteil der im Leuchtdiodenchip erzeugten elektromagnetischen Strahlung in Hauptabstrahlrichtung austritt, ferner ein Gehäuse, das den Leuchtdiodenchip seitlich umschließt und eine reflektive Optik, die der Strahlungsauskoppelfläche in Hauptabstrahlrichtung nachgeordnet ist.

Bevorzugt enthält der Leuchtdiodenchip einen epitaktisch gewachsenen Schichtstapel. Der Schichtstapel ist beispielsweise eine Abfolge von epitaktisch gewachsenen Schichten. Bevorzugt umfasst der Schichtstapel wenigstens eine aktive Zone, die zur Erzeugung elektromagnetischer Strahlung geeignet ist. Bevorzugt ist die aktive Zone zur Erzeugung von elektromagnetischer Strahlung im blauen oder ultravioletten Spektralbereich geeignet.

Dazu kann die aktive Zone beispielsweise einen pn-Übergang, eine Doppelheterostruktur, einen Einfach-Quantentopf oder besonders bevorzugt eine Mehrfach-Quantentopfstruktur (MQW) aufweisen. Solche Strukturen sind dem Fachmann bekannt und werden daher an dieser Stelle nicht näher erläutert. Beispiele für MQW-Strukturen sind in den Druckschriften WO 01/39282, WO 98/31055, US 5,831,277, EP 1 017 113 und US 5,684,309 beschrieben, deren Offenbarungsgehalt die MQW-Strukturen betreffend hiermit durch Rückbezug aufgenommen wird.

Der Schichtstapel ist besonders bevorzugt eine Abfolge von epiktaktisch gewachsenen Schichten, von denen das Aufwachssubstrat nach Abschluss des epiktaktischen Wachstums entfernt worden ist. Besonders bevorzugt ist auf die dem ursprünglichen Aufwachssubstrat abgewandte Oberfläche des Schichtstapels ein Träger aufgebracht. Bauteile, die unter Entfernen des Aufwachssubstrats von einer epiktaktisch gewachsenen Schichtfolge hergestellt sind, werden oftmals auch mit dem Oberbegriff Dünnfilmschicht-Bauteile bezeichnet.

Ein Grundprinzip eines Dünnfilmschicht-Bauteils ist beispielsweise in I. Schnitzer at al., Appl. Phys. Lett. 63(16), 18. Oktober 1993, Seiten 2174 bis 2176, beschrieben, deren Offenbarungsgehalt bezüglich des- Grundprinzips von Dünnfilmschichtbauteilen hiermit durch Rückbezug aufgenommen wird.

Ein Dünnfilmleuchtdiodenchip ist in guter Nährung eine Lambertscher Oberflächenstrahler und eignet sich von daher besonders gut beispielsweise für die Anwendung in einem Scheinwerfer.

Besonders vorteilhaft ist, dass der Träger, verglichen mit dem Aufwachssubrat, relativ frei gewählt werden kann. So kann der Träger hinsichtlich mancher Eigenschaften wie etwa Leitfähigkeit oder Stabilität für das Bauteil besser geeignet sein, als verfügbare Aufwachssubstrate, die zur Herstellung hochwertiger, epiktaktisch gewachsener Schichtfolgen engen Einschränkungen unterliegen. So muss, um hochwertige epiktaktische Schichten zu erhalten, das epiktaktisch abgeschiedene Material beispielsweise gitterangepasst zum Aufwachssubstrat sein.

Bevorzugt zeichnet sich der auf dem Schichtstapel aufgebrachte Träger durch einen an den Schichtstapel angepassten thermischen Ausdehnungskoeffizienten aus. Beispielsweise kann der Träger ein Halbleitermaterial wie Germanium, Gallium-Arsenid, Gallium-Nitrid, Silizium-Carbid und andere Materialien wie Saphir, Molybdän oder Metalle enthalten.

Außerdem zeichnet sich der Träger bevorzugt durch eine besonders gute thermische Leitfähigkeit aus, so dass die bei der Erzeugung von elektromagnetischer Strahlung in der aktiven Zone entstehende Wärme zumindest teilweise über den Träger an die Umgebung abgegeben werden kann.

Gemäß einer bevorzugten Ausgestaltung des Leuchtdiodenchips ist zwischen dem aufgebrachten Träger und dem Schichtstapel eine Spiegelschicht angeordnet. Die Spiegelschicht kann beispielsweise einen Bragg-Spiegel oder eine metallhaltige Spiegelschicht umfassen. Ein metallhaltiger Spiegel, der beispielsweise Gold, Gold-Germanium, Silber, Aluminium oder Platin enthalten kann, zeichnet sich gegenüber einem Bragg-Spiegel beispielsweise durch eine geringere Richtungsabhängigkeit der Reflektivität aus. Auch lässt sich mit metallhaltigen Spiegeln eine höhere Reflektivität als mit Bragg-Spiegeln erreichen.

In zumindest einer Ausführungsform der Leuchtdiodenanordnung ist der Leuchtdiodenchip geeignet, besonders kurze Lichtimpulse zu erzeugen. Beispielsweise ist der Leuchtdiodenchip geeignet, Blitzlicht zu erzeugen mit einer Beleuchtungsdauer von maximal 200 Millisekunden. Bevorzugt beträgt die Beleuchtungsdauer maximal 120 Millisekunden, besonders bevorzugt maximal 100 Millisekunden.

In wenigstens einer Ausführungsform der Leuchtdiodenanordnung ist der Leuchtdiodenchip geeignet, elektromagnetische Strahlung im Dauerbetrieb zu erzeugen. Bevorzugt ist der Leuchtdiodenchip geeignet, Licht von in etwa gleichbleibender Intensität für wenigstens 5 Minuten bereitzustellen. In etwa gleichbleibende Intensität bedeutet in diesem Zusammenhang, dass es zu leichten Schwankungen der Lichtintensität, etwa bedingt durch Schwankungen in der Stromversorgung oder durch thermische Effekte, kommen kann. Diese sind jedoch so gering, dass diese vom menschlichen Auge nicht wahrgenommen werden können.

Gemäß wenigstens einer Ausführungsform der Leuchtdiodenanordnung ist der Leuchtdiodenchip geeignet, sowohl Blitzlicht mit einer Beleuchtungsdauer von maximal 200 Millisekunden, bevorzugt maximal 120 Millisekunden, besonders bevorzugt maximal 100 Millisekunden zu erzeugen und im Dauerbetrieb für wenigstens fünf Minuten mit in etwa gleich bleibender Intensität elektromagnetische Strahlung abzugeben.

Entsprechend zumindest einer Ausführungsform der Leuchtdiodenanordnung weist die reflektive Optik eine Lichteingangsöffnung auf, durch die ein Großteil der im Leuchtdiodenchip erzeugten elektromagnetischen Strahlung in die reflektive Optik eintritt. Die Lichteingangsöffnung der reflektiven Optik ist dabei bevorzugt der Strahlungsauskoppelfläche des Leuchtdiodenchips in Hauptabstrahlrichtung nachgeordnet. Bevorzugt weist die Lichteingangsöffnung eine Fläche auf, die maximal zwei mal so groß, besonders bevorzugt maximal 1,05 bis 1,20 mal so groß wie die Strahlungsauskoppelfläche des Leuchtdiodenchips ist. Eine solche kleine Lichteingangsöffnung der reflektiven Optik erweist sich als besonders vorteilhaft, da sie eine signifikante Miniaturisierung der Leuchtdiodenanordnung ermöglicht.

Weist die Leuchtdiodenanordnung mehr als einen Leuchtdiodenchip auf, denen die reflektierende Optik nachgeordnet ist, so weist die Lichteintrittsöffnung bevorzugt eine Fläche auf, die maximal zwei mal so groß, besonders bevorzugt maximal 1,05 bis 1,20 mal so groß wie die die Summe der Strahlungsauskoppelflächen der Leuchtdiodenchips.

Nach wenigstens einer Ausführungsform der Leuchtdiodenanordnung weist die reflektive Optik eine Lichtausgangsöffnung auf. Durch die Lichteingangsöffnung in die reflektive Optik eingetretene elektromagnetische Strahlung verlässt die reflektive Optik bevorzugt durch die Lichtausgangsöffnung. Vorzugsweise ist die Lichtausgangsöffnung der Lichteingangsöffnung in der Hauptabstrahlrichtung der vom Leuchtdiodenchip erzeugten elektromagnetischen Strahlung nachgeordnet.

Besonders bevorzugt weist die reflektive Optik zwischen der Lichteingangsöffnung und der Lichtausgangsöffnung reflektierende Seitenwände auf. Die reflektierenden Seitenwände sind bevorzugt so ausgestaltet, dass sie zumindest einen Teil der durch die Lichteingangsöffnung eintretenden elektromagnetischen Strahlung in Richtung der Lichtausgangsöffnung hin reflektieren.

Gemäß wenigstens einer Ausführungsform der Leuchtdiodenanordnung weist die reflektive Optik Seitenwände auf, die mit einer Schicht oder Schichtenfolge, bevorzugt mit einer metallischen Schicht, versehen sind, die für ein von dem Halbleiterchip ausgesandtes Licht reflektierend sind.

In zumindest einer Ausführungsform der Leuchtdiodenanordnung ist die reflektive Optik in das Gehäuse, das den Leuchtdiodenchip seitlich umgibt, integriert. Das heißt, dass die Seitenwände der reflektiven Optik beispielsweise durch die dem Leuchtdiodenchip zugewandten Innenwände des Gehäuses gegeben sind. Dies ist beispielsweise dadurch erreicht, dass die inneren Gehäusewände reflektierend beschichtet sind. Die Beschichtung der Gehäuseinnenwände besteht dabei wiederum bevorzugt aus einer metallischen Schicht oder Schichtenfolge.

Alternativ ist der Grundkörper der reflektiven Optik vorteilhaft aus einem dielektrischen Material mit geeignetem Brechungsindex gebildet. Auf diese Weise wird über die Lichteingangsöffnung eingekoppeltes Licht durch Totalreflexion an den die Lichteingangsöffnung mit der Lichtausgangsöffnung verbindenden Wänden des Gehäuses reflektiert. Dies hat den Vorteil, dass es in der reflektiven Optik praktisch keine Lichtverluste aufgrund von Reflexionen gibt. In dieser Ausführungsform der Leuchtdiodenanordnung ergibt sich zudem vorteilhaft die Möglichkeit, dass das Gehäuse durch den Grundkörper der reflektiven Optik gebildet ist. Vorteilhaft kann die Leuchtdiodenanordnung auf diese Weise besonders kostengünstig produziert werden.

In wenigsten einer Ausführungsform der Leuchtdiodenanordnung ist die reflektive Optik derart gebildet, dass sie die Divergenz der vom Leuchtdiodenchip abgegebenen Strahlung reduziert. Das heißt, die durch die Lichteingangsöffnung in die reflektive Optik eintretende elektromagnetische Strahlung weist beim Lichteintritt eine größere Divergenz auf, als beim Lichtaustritt durch die Lichtausgangsöffnung der reflektiven Optik. Bevorzugt ist die reflektive Optik eine nicht abbildende Optik.

Gemäß zumindest einer Ausführungsform ist die reflektive Optik ein optischer Konzentrator, wobei die Lichteingangsöffnung der reflektiven Optik die eigentliche Lichtausgangsöffnung des Konzentrators ist. Besonders bevorzugt ist die reflektive Optik ein nicht-abbildender optischer Konzentrator. Verglichen mit der üblichen Anwendung eines optischen Konzentrators zum Fokussieren läuft das Licht in umgekehrter Richtung durch den optischen Konzentrator und wird somit nicht konzentriert, sondern es verlässt den Konzentrator mit verringerter Divergenz durch die Lichtausgangsöffnung.

In zumindest einer Ausführungsform der Leuchtdiodenanordnung ist die reflektive Optik zumindest teilweise nach Art eines zusammengesetzten parabolischen Konzentrators (Compound Parabolic Concentrator, CPC), eines zusammengesetzten elliptischen Konzentrators (Compound Elliptic Concentrator, CEC) eines zusammengesetzten hyperbolischen Konzentrators (Compound Hyperbolic Concentrator, CHC), oder einer TIR (Total Internal Reflection) Optik gebildet. Das heißt, die reflektierenden Seitenwände der reflektiven Optik sind zumindest teilweise in der Form eines CPC, CEC, CHC oder einer TIR gebildet. Weiterhin ist es vorteilhaft möglich, dass die reflektive Optik als eine Kombination dieser optischen Elemente gebildet ist. Eine derart gestaltete reflektive Optik ermöglicht vorteilhaft, eine effiziente Verringerung der Divergenz der vom Leuchtdiodenchip erzeugten elektromagnetischen Strahlung und somit eine wohldefinierte Abstrahlcharakteristik der Leuchtdiodenanordnung.

In wenigstens einer Ausführungsform der Leuchtdiodenanordnung weist die reflektive Optik eine Lichtausgangsöffnung auf, durch die ein Großteil der im Leuchtdiodenchip erzeugten elektromagnetischen Strahlung aus der reflektiven Optik austritt. Der Lichtausgangsöffnung der reflektiven Optik ist dabei in der Hauptabstrahlrichtung ein Abdeckkörper nachgeordnet. Bevorzugt ist dieser Abdeckkörper zumindest teilweise für die elektromagnetische Strahlung durchlässig. Der Abdeckkörper dient bevorzugt als Schutz der reflektiven Optik sowie des Leuchtdiodenchips vor Staub- und Schmutzpartikeln sowie vor mechanischer Einwirkung. Besonders bevorzugt ist der Abdeckkörper als Gehäusedeckel für die Leuchtdiodenanordnung ausgebildet. Dabei kann der Abdeckkörper vorteilhaft bei der Montage der Leuchtdiodenanordnung in ein Systemgehäuse als Führung oder Anschlag dienen, so dass er eine einfache und mechanisch stabile Montage der Leuchtdiodenanordnung in das Systemgehäuse ermöglicht. Besonders bevorzugt dient der Abdeckkörper als Führung und Anschlag.

Das heißt, die Leuchtdiodenanordnung kann beispielsweise dafür vorgesehen sein, in einer Ausnehmung eines Systemgehäuses versenkt zu werden. Der Abdeckkörper und die Ausnehmung sind dann derart einander angepasst, dass die der Abdeckkörper als Führung und/oder Anschlag bei der Montage der Leuchtdiodenanordnung fungiert.

Gemäß zumindest einer Ausführungsform der Leuchtdiodenanordnung enthält der Abdeckkörper ein optisches Element. Das heißt, in den Abdeckkörper ist bevorzugt eine Optik integriert, die zur Beugung, Brechung oder Wellenlängen-Konvertierung der aus der Lichtausgangsöffnung der reflektiven Optik austretenden elektromagnetischen Strahlung dient. Besonders bevorzugt erfüllt das optische Element wenigstens zwei dieser Aufgaben. Das optische Element ist bevorzugt eine nicht abbildende Optik.

In wenigstens einer Ausführungsform weist das optische Element eine Lichtausgangsfläche auf, die beispielsweise sphärisch oder asphärisch gewölbt sein kann. Dadurch kann eine weitere Verringerung der Divergenz der aus der Leuchtdiodenanordnung austretenden elektromagnetischen Strahlung erreicht werden.

Bevorzugt ist die Lichtausgangsfläche nach Art einer asphärischen Linse gewölbt. Das heißt, die Lichtausgangsöffnung ist eine zur Brechung des austretenden Lichtbündels dienende optische Fläche, die weder kugelförmig noch eben ist. Besonders bevorzugt kann ein derart gebildetes optisches Element eine Vielzahl von Formparametern aufweisen, wodurch etwa der Größe der Strahlungsauskoppelfläche des Leuchtdiodenchips und/oder der Lichtausgangsöffnung der reflektiven Optik Rechnung getragen werden kann. Im Gegensatz dazu sind sphärische Linsen für punktförmige Lichtquellen optimal und können bei nicht punktförmigen Lichtquellen signifikant schlechtere Eigenschaften hinsichtlich einer Verringerung der Divergenz des austretenden Lichtbündels aufweisen.

In zumindest einer Ausführungsform der Leuchtdiodenanordnung ist das optische Element nach Art einer Fresnel-Linse gebildet. Auch die Fresnel-Linse ist geeignet, die Divergenz der austretenden Strahlung zu verringern. Besonders vorteilhaft zeichnet sich die Fresnel-Linse durch ein besonders kostengünstiges Herstellungsverfahren aus.

In wenigstens einer Ausführungsform der Leuchtdiodenanordnung ist dem Leuchtdiodenchip in Hauptabstrahlrichtung ein Lumineszenz-Konversionsmaterial nachgeordnet, welches zumindest einen Teil der vom Leuchtdiodenchip emittierten elektromagnetischen Strahlung wellenlängenkonvertiert. Das Lumineszenz-Konversionsmaterial enthält vorteilhaft wenigstens eine Art von Leuchtstoffpartikeln. Dazu eignen sich beispielsweise anorganische Leuchtstoffe wie seltene Erden, dotierte Granate (beispielsweise YAG:Ce) oder organische Leuchtstoffe wie Perylen-Leuchtstoffe. Weitere geeignete Leuchtstoffe sind beispielsweise in der Druckschrift WO 98/12757 aufgeführt, deren Inhalt hinsichtlich der Leuchtstoffe durch Rückbezug aufgenommen wird.

Mit Hilfe des Lumineszenz-Konversionsmaterials kann entweder durch weitgehend vollständige Konversion einer Primärstrahlung des Leuchtdiodenchips oder durch gezielte teilweise Konversion und Mischung von Primärstrahlung und konvertierter Strahlung sichtbares Licht eines gewünschten Farbortes auf der CIE-Farbtafel, insbesondere weißes Licht erzeugt werden.

Gemäß zumindest einer Ausführungsform der Leuchtdiodenanordnung ist das Lumineszenz-Konversionsmaterial als dünne Schicht auf die Strahlungsauskoppelfläche des Leuchtdiodenchips aufgebracht. Besonders bevorzugt beträgt die Schichtdicke maximal 50 *µ*m. Die minimale Dicke der Lumineszenz-Konversionsschicht beträgt etwa 5 *µ*m. Die Lumineszenz-Konversionsschicht enthält dabei vorteilhaft ein Lumineszenz-Konversionsmaterial-Matrixgemisch. Die Matrix ist beispielsweise aus duroplastischen Polymeren oder Silikon gebildet. Der Gehalt an Lumineszenz-Konversionsmaterial ist vorteilhaft hoch.

Es erweist sich bei dieser Ausführungsform der Leuchtdiodenanordnung als besonders vorteilhaft, dass ein Großteil der vom Leuchtdiodenchip erzeugten elektromagnetischen Strahlung durch die Strahlungsauskoppelfläche austritt. Da die Lumineszenz-Konversionsschicht direkt auf der Strahlungsauskoppelfläche aufgebracht ist, ermöglicht diese Anordnung eine besonders effiziente und definierte Konversion der austretenden Strahlung. Das heißt, der überwiegende Anteil der aus dem Leuchtdiodenchip austretenden elektromagnetischen Strahlung wird zu Licht eines vorgebbaren Farbtons wellenlängenkonvertiert.

In wenigstens einer Ausführungsform der Leuchtdiodenanordnung ist der Strahlungsauskoppelfläche des Leuchtdiodenchips in Hauptabstrahlrichtung ein Plättchen nachgeordnet, das ein Lumineszenz-Konversionsmaterial enthält. Die Dicke des Plättchens beträgt bevorzugt maximal 200 *µ*m. Die minimale Dicke des Plättchens beträgt vorzugsweise circa 10 *µ*m. Das Plättchen kann beispielsweise ein Kunststoffmaterial enthalten, in das das Lumineszenz-Konversionsmaterial eingearbeitet ist. Es ist aber auch möglich, dass das Plättchen mit einer Schicht aus Lumineszenz-Konversionsmaterial beschichtet wird. Das Plättchen kann dann beispielsweise aus Glas gebildet sein. Besonders vorteilhaft ergibt sich, dass eine Leuchtdiodenanordnung mit solch einem Plättchen besonders einfach und kostengünstig hergestellt werden kann. Außerdem ergibt sich die Möglichkeit durch Austausch des Plättchens auf besonders einfache Weise den Farbort des von der Leuchtdiodenanordnung abgegebenen Lichts zu verändern.

In zumindest einer Ausführungsform der Leuchtdiodenanordnung enthält das optische Element ein Lumineszenz-Konversionsmaterial, das heißt, das optische Element verringert die Divergenz der austretenden Strahlung und trägt gleichzeitig zur Wellenlängenkonvertierung dieser Strahlung bei. Diese Ausführungsform der Leuchtdiodenanordnung ermöglicht vorteilhaft die Herstellung besonders kostengünstiger Leuchtdiodenanordnungen. Enthält das optische Element einen Kunststoff, so kann das Lumineszenz-Konversionsmaterial vorteilhaft in den Kunststoff eingearbeitet sein. Es ist aber auch möglich, dass das -optische Element mit dem Lumineszenz-Konversionsmaterial beschichtet ist. Besonders vorteilhaft kann das optische Element dann aus Glas gebildet sein.

Nach wenigstens einer Ausführungsform der Leuchtdiodenanordnung enthält die reflektive Optik ein Lumineszenz-Konversionsmaterial. Das heißt, die reflektive Optik verringert die Divergenz des austretenden Lichts und trägt gleichzeitig zur Wellenlängenkonvertierung der vom Leuchtdiodenchip abgegebenen elektromagnetischen Strahlung bei. Je nach den Anforderungen an das von der Leuchtdiodenanordnung emittierte Licht, sind dabei verschiedene Anordnungen der Konzentration von Lumineszenz-Konversionsmaterial in der reflektiven Optik möglich. So kann eine besonders hohe Konzentration von Lumineszenz-Konversionsmaterial zum Beispiel im der Leuchtdiode zugewandten Bereich der reflektiven Optik vorhanden sein. Es ist aber auch möglich, dass die Konzentration von Lumineszenz-Konversionsmaterial in der Mitte im Strahlungsaustrittsbereich der reflektiven Optik besonders hoch ist. Insgesamt wird durch die Variation der Lumineszenz-Konversionsmaterial-Konzentration eine definierte Konversion der austretenden Strahlung ermöglicht.

Gemäß wenigstens einer Ausführungsform der Leuchtdiodenanordnung beträgt der Öffnungswinkel eines vom Lichtausgang der Leuchtdiodenanordnung, beispielsweise der Lichtausgangsfläche des optischen Elements, austretenden Lichtkegels maximal 35 Grad. Besonders bevorzugt beträgt der Öffnungswinkel zwischen 25 Grad und 35 Grad. Lichtkegel bedeutet in diesem Zusammenhang ein Volumen, das durch das vom Lichtausgang der Leuchtdiodenanordnung emittierte Licht ausgeleuchtet ist, wobei Bereiche ausgeschlossen sind, in denen die Helligkeit mehr als-eine Größenordnung geringer ist als die maximale Helligkeit bei gleichem Abstand zum Lichtausgang. Ein Lichtkegel in diesem Sinne bezieht sich nicht auf die Form eines Kegels im mathematischen Sinne und kann demnach mehr als einen Öffnungswinkel aufweisen. Ist dies der Fall, so beziehen sich obige Angaben des Öffnungswinkels auf den maximalen Öffnungswinkel. Besonders bevorzugt ist die Leuchtdiodenanordnung dabei geeignet, eine in circa drei Meter Abstand befindliche Fläche von circa fünf bis sechs Quadratmeter Größe mit wenigstens zehn Lux auszustrahlen. Dabei finden ein oder mehrere Leuchtdiodenchips in der Leuchtdiodenanordnung Verwendung mit einer Gesamtstrahlungsauskoppelfläche von circa einem Quadratmillimeter.

In zumindest einer Ausführungsform der Leuchtdiodenanordnung weist die von der Leuchtdiodenanordnung ausgestrahlte Fläche eine rechteckige Form auf. Bevorzugt verhalten sich die Seiten der rechteckigen Fläche im Verhältnis vier zu drei zueinander.

Nach wenigstens einer Ausführungsform der Leuchtdiodenanordnung ist der Leuchtdiodenchip mit seiner der Strahlungsauskoppelfläche gegenüberliegenden Oberfläche auf einem Kühlkörper aufgebracht. Der Kühlkörper enthält beispielsweise eines der folgenden Materialien: Keramik, Halbleitermaterialien, Metalle. Vorteilhafterweise weist der Kühlkörper eine hohe thermische Leitfähigkeit auf und ist in seinem thermischen Ausdehnungskoeffizienten dem Material des Leuchtdiodenchips angepasst. Der Leuchtdiodenchip ist bevorzugt auf den Kühlkörper gelötet oder aufgeklebt. Die Klebverbindung zeichnet sich vorzugsweise durch eine hohe thermische Leitfähigkeit aus. Bevorzugt befinden sich auf der dem Leuchtdiodenchip abgewandten Oberfläche des Kühlkörpers elektrische Kontaktflächen isoliert zueinander. Die elektrischen Kontaktflächen sind vorzugsweise mit den jeweiligen Anschlüssen des Leuchtdiodenchips verbunden. Über die elektrischen Kontaktflächen kann der Leuchtdiodenchip elektrisch kontaktiert werden.

Gemäß wenigstens einer Ausführungsform der Leuchtdiodenanordnung ist der Kühlkörper mit seiner dem Leuchtdiodenchip abgewandten Seite auf einem Träger aufgebracht. Besonders bevorzugt sind zwischen Träger und Kühlkörper dabei Kontaktfedern aufgebracht, die mit den Kontaktflächen auf der dem Leuchtdiodenchip abgewandten Oberfläche des Kühlkörpers verbunden sind.

Die Kontaktfedern sind bevorzugt in einem spitzen Winkel um den Träger gebogen. Die Biegung der Kontaktfedern ist vorteilhaft so gestaltet, dass die Biegekräfte die Montageverbindung zwischen Kühlkörper und Träger nicht belasten. Bevorzugt sind die Federn auf Kühlkörper und Träger aufgelötet.

Nach wenigstens einer Ausführungsform der Leuchtdiodenanordnung betragen ihre äußeren Abmessungen wenigstens in einer Raumrichtung maximal vier Millimeter. Besonders bevorzugt betragen die äußeren Abmessungen der Leuchtdiodenanordnung in allen drei Raumrichtungen maximal vier Millimeter. Dies ermöglicht vorteilhaft den Einsatz der Leuchtdiodenanordnung in relativ kleinen Geräten.

Besonders bevorzugt ist die Verwendung der Leuchtdiodenanordnung in einem der folgenden Geräte: Handy, Videokamera, Photoapparat. In diesen Geräten kann die Leuchtdiodenanordnung sowohl als Blitzlicht-als-auch zur Dauerbeleuchtung von zum Beispiel Filmszenen eingesetzt werden. Besonders vorteilhaft erweist sich dabei, dass die Leuchtdiodenanordnung eine besonders effiziente Kühlung des Leuchtdiodenchips ermöglicht. Damit kann der Leuchtdiodenchip bei hohen Leistungen betrieben werden. Dies ermöglicht eine Ausleuchtung mit hoher Lichtintensität über einen langen Zeitraum, ohne dass ein Überhitzen der Leuchtdiodenanordnung eintreten kann.

Im Folgenden wird die hier beschriebene Leuchtdiodenanordnung anhand von Ausführungsbeispielen und den dazugehörigen Figuren näher erläutert.
Figur 1 zeigt eine schematische dreidimensionale Schnittansicht eines ersten Ausführungsbeispiels der hier beschriebenen Leuchtdiodenanordnung.
Figur 2 zeigt eine schematische dreidimensionale Schnittansicht eines zweiten Ausführungsbeispiels der hier beschriebenen Leuchtdiodenanordnung.
Figur 3 zeigt eine dreidimensionale Ansicht eines Ausführungsbeispiels der hier beschriebenen Leuchtdiodenanordnung.
Figur 4 zeigt eine schematische Schnittansicht eines Ausführungsbeispiels der hier beschriebenen Leuchtdiodenanordnung.
Figur 5 zeigt eine schematische Schnittansicht eines weiteren Ausführungsbeispiels der hier beschriebenen - Leuchtdiodenanordnung.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

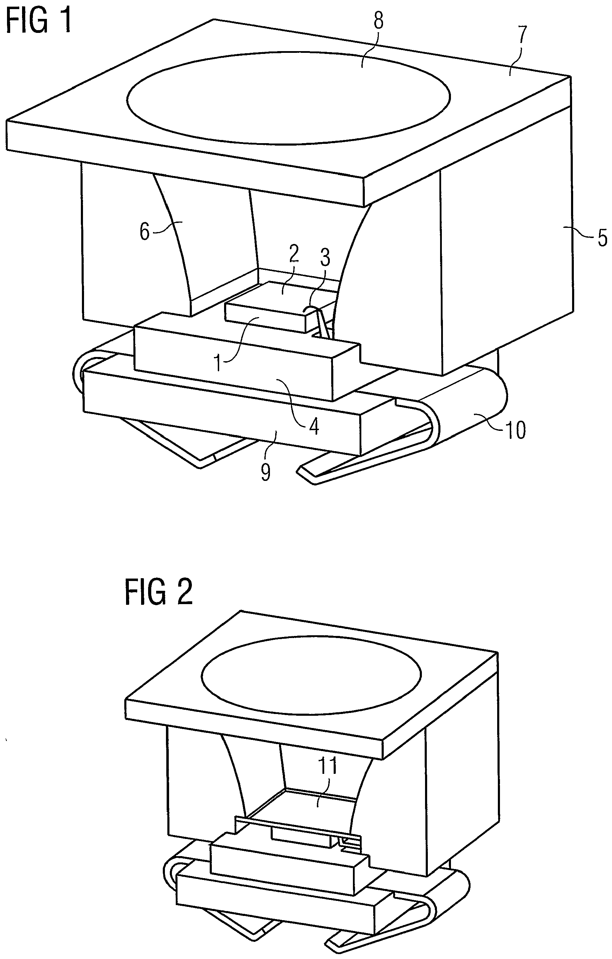

Figur 1 zeigt eine schematische dreidimensionale Schnittansicht eines ersten Ausführungsbeispiels der hier beschriebenen Leuchtdiodenanordnung.

Beim Leuchtdiodenchip 1 der Leuchtdiodenanordnung handelt es sich bevorzugt um einen Leuchtdiodenchip 1 in Dünnfilmbauweise, wie er im allgemeinen Teil der Beschreibung beschrieben ist. Der Leuchtdiodenchip 1 zeichnet sich vor allem durch seine vorteilhaft kleine Etendue aus.

Die von der aktiven Zone des Leuchtdiodenchip 1 erzeugte elektromagnetische Strahlung tritt größtenteils durch die Strahlungsauskoppelfläche 2 aus. Die Größe der Strahlungsauskoppelfläche beträgt in etwa einen Quadratmillimeter.

Der Strahlungsauskoppelfläche 2 in der Hauptabstrahlrichtung des Leuchtdiodenchips 1 nachgeordnet, ist beispielsweise eine Schicht aus Lumineszenz-Konversionsmaterial, die auf die Strahlungsauskoppelfläche 2 aufgebracht ist (nicht dargestellt). Durch die Lumineszenz-Konversionsmaterialschicht wird das aus der Strahlungsauskoppelfläche 2 austretende Licht zumindest teilweise wellenlängenkonvertiert. Bevorzugt entsteht dabei durch Lichtmischung der vom Leuchtdiodenchip emittierten Primärstrahlung und dem wellenlängenkonvertierten Teil der Strahlung weißes Licht.

Die Lumineszenz-Konversionsschicht enthält vorteilhaft ein Lumineszenz-Konversionsmaterial-Matrixgemisch. Die Matrix ist beispielsweise aus duroplastischen Polymeren wie Epoxymaterialien oder Silikonmaterialien gebildet. Der Gehalt an Lumineszenz-Konversionsmaterial ist vorteilhaft hoch. Besonders bevorzugt ist der Matrix zwischen 30 und 50 Volumenprozent Leuchtstoffmaterial beigemischt.

Zum Beispiel seitlich auf der Strahlungsauskoppelfläche 2 ist ein Bondpad 3 aufgebracht, über das der Chip elektrisch kontaktiert werden kann.

Mit seiner der Strahlungsauskoppelfläche 2 gegenüberliegenden Hauptfläche ist der Leuchtdiodenchip 1 auf dem Kühlkörper 4 aufgebracht. Der Kühlkörper 4 dient bevorzugt als Wärmesenke. Er enthält beispielsweise ein keramisches Material wie beispielsweise AlN, ein Halbleitermaterial wie beispielsweise Silizium oder einen Metallverbund. Vorteilhaft kann der Kühlkörper 4 auch eine Kombination dieser Materialien enthalten. Der Leuchtdiodenchip 1 ist auf den Kühlkörper 4 vorzugsweise aufgelötet oder hochthermisch leitfähig geklebt. Der Kühlkörper 4 dient zur Aufnahme und Weitergabe der vom Leuchtdiodenchip 1 im Betrieb erzeugten Wärme. Bevorzugt enthält der Kühlkörper 4 Durchkontaktierungen (Vias), zum elektrischen Kontaktieren des Leuchtdiodenchips 1.

Auf den Kühlkörper 4 ist ein Gehäuse 5 aufgebracht, das den Leuchtdiodenchip 1 seitlich umgibt. Vorzugsweise umschließt das Gehäuse den Leuchtdiodenchip 1 dabei seitlich komplett. Das Gehäuse 5 kann dabei wenigstens eines der folgenden Materialien enthalten: Al₂O₃, AlN, ZO, FeNi, Kovar, Cu, Molybdän, LCP, PPA, PEEK.

In die Innenwände des Gehäuses 5 integriert, auf die Innenwände des Gehäuses 5 aufgebracht oder durch die Innenwände des Gehäuses gebildet ist eine reflektive Optik 6, die geeignet ist, das vom Leuchtdiodenchip abgegebene und gegebenenfalls wellenlängenkonvertierte Licht zu reflektieren und die Divergenz der austretenden Strahlung dabei zu verringern. Bevorzugt ist die reflektive Optik 6 dabei nach Art eines CPC, CEC, CHC, einer TIR (total internal reflection) Optik oder einer Kombination dieser optischen Elemente gebildet. Bevorzugt ist die reflektive Optik eine nicht abbildende Optik.

Dem Gehäuse 6 ist ein Abdeckkörper 7 nachgeordnet, in den ein optisches Element 8 integriert ist, das durch eine nicht abbildende Optik gebildet ist. Das optische Element ist ebenfalls geeignet, die Divergenz der aus der Leuchtdiodenanordnung austretenden Strahlung zu reduzieren.

Auf der dem Leuchtdiodenchip 1 abgewandten Oberfläche des Kühlkörpers 4 sind ein Träger 9 und Kontaktfedern 10 aufgebracht. Auch der Träger 9 dient zur Ableitung der vom Leuchtdiodenchip im Betrieb erzeugten Wärme und zeichnet sich durch eine hohe thermische Leitfähigkeit aus. Vorteilhaft kann der Leuchtdiodenchip 1 mit Strömen zwischen 0,5 und 1,0 Ampère betrieben werden. Aufgrund der effizienten Kühlung kann der Leuchtdiodenchip auch für längere Zeiten elektromagnetische Strahlung hoher Intensität abgeben, ohne dass eine Überhitzung der Anordnung auftreten kann. Der Träger 9 enthält dazu bevorzugt ein elektrisch isolierendes Material oder besteht aus einem solchen. Besonders bevorzugt enthält der Träger beispielsweise Kunststoffe oder Kohlefaser gefüllte Kunststoffe.

Die Kontaktfedern 10 enthalten beispielsweise CuFe₂P oder CuBe und dienen beispielsweise als Wärmeleitelemente zum Abführen von vom Leuchtdiodenchip 1 im Betrieb erzeugter Wärme. Außerdem ist es möglich, dass der Leuchtdiodenchip 1 mittels der Kontaktfedern 10 elektrisch kontaktiert werden kann. Träger 9 und Federn 10 erlauben zusätzlich einen Höhenausgleich bei der Montage der Leuchtdiodenanordnung in ein Systemgehäuse. Das heißt, durch Anpassung beispielsweise der Dicke des Trägers 9 und/oder dem Winkel in dem die Federn 10 um den Träger 9 gebogen sind und/oder der Länge der Federn 10, kann die Leuchtdiodenanordnung an die Tiefe einer Ausnehmung im Systemgehäuse angepasst sein.

Figur 2 zeigt eine Leuchtdiodenanordnung, die sich dadurch von dem eben beschriebenen Ausführungsbeispiel unterscheidet, dass statt einer Konversionsschicht auf der Strahlungsauskoppelfläche 2 des Leuchtdiodenchips 1 ein Plättchen 11 der Strahlungsauskoppelfläche 2 nachgeordnet ist. Dieses Plättchen 11 kann beispielsweise ein Kunststoffmaterial enthalten, dem ein Lumineszenz-Konversionsmaterial beigemengt ist oder aus einem Glasplättchen bestehen, das an einer seiner beiden Hauptflächen, die parallel zur Strahlungsauskoppelfläche 2 verlaufen, mit einem Lumineszenz-Konversionsmaterial beschichtet ist. Das Plättchen dient zur Wellenlängenkonvertierung wenigstens eines Teils der vom Leuchtdiodenchip 2 abgegebenen elektromagnetischen Strahlung.

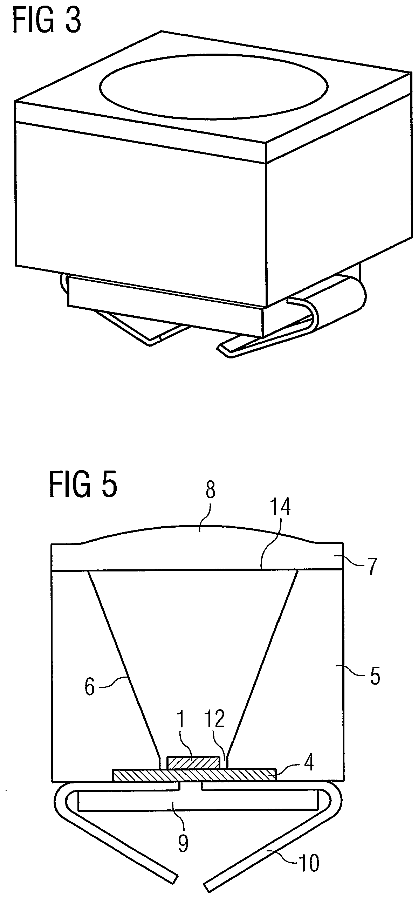

Figur 3 zeigt die Leuchtdiodenanordnung mit allen vier Seitenwänden geschlossen. Die Abmessungen der Leuchtdiodenanordnung betragen vorzugsweise circa 4x4x4 Millimeter. Aufgrund dieser kleinen Abmessungen kann die Leuchtdiodenanordnung vorteilhaft zum Beispiel auch in relativ kleinen elektronischen Geräten wie Fotohandys oder Digitalkameras eingesetzt werden.

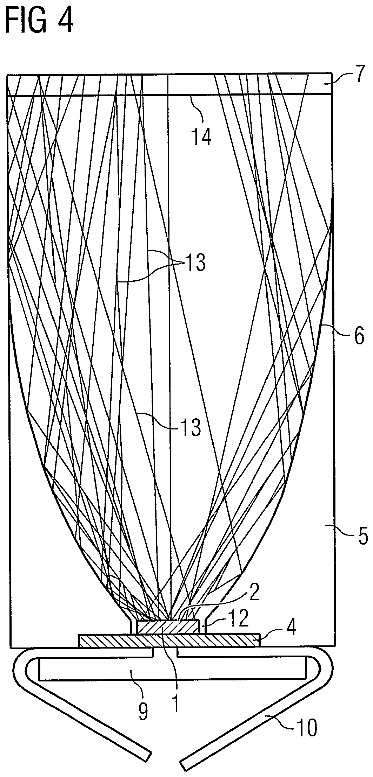

Figur 4 zeigt ein Ausführungsbeispiel der Leuchtdiodenanordnung in einer Schnittansicht. Aus der Strahlungsauskoppelfläche 2 tritt die im Leuchtdiodenchip 1 erzeugte elektromagnetische Strahlung 13 in die reflektierende Optik 6 ein, die hier als ein CPC-artiger optischer Konzentrator gebildet ist. Der CPC-artige optische Konzentrator zeichnet sich durch seine parabolisch geformten Seitenflächen aus. Der optische Konzentrator wird in umgekehrter Richtung zum Verringern der Divergenz der vom Leuchtdiodenchip 1 emittierten Strahlung 13 verwendet. Das heißt, die Lichteingangsöffnung 12 der reflektiven Optik 6 ist die eigentliche Lichtausgangsöffnung des optischen Konzentrators, wohingegen die Lichtausgangsöffnung 14 der reflektiven Optik 6 die eigentliche Lichteingangsöffnung des optischen Konzentrators ist. Die reflektive Optik ist hier beispielsweise durch eine reflektive Beschichtung gebildet, die aus einer Schicht oder einer Schichtenfolge zum Beispiel aus einer Metallschicht aus Silber gebildet ist.

Figur 5 zeigt ein weiteres Ausführungsbeispiel der Leuchtdiodenanordnung in einer Schnittansicht.

Die reflektierende Optik 6 weist hier Seitenwände auf, die in gerader Linie von der Lichteingangsöffnung 12 des optischen Elements 6 zur Lichtausgangsöffnung 14 des optischen Elements 6 verlaufen.

Die Seitenwände des optischen Elements sind dabei beispielsweise reflektierend beschichtet. In diesem Ausführungsbeispiel der Leuchtdiodenanordnung bilden die Seitenwände der reflektierenden Optik 6 also einen Pyramiden- oder Kegelstumpf. Die Seitenwände des optischen Elements 6 können dabei beispielsweise reflektierend beschichtet sein.

Zusätzlich ist der Lichtausgangsöffnung 14 der reflektierenden Optik 6 ein zweites optisches Element 8 nachgeordnet, das nach Art einer sphärischen oder asphärischen Linse nach außen gewölbt ist und zusätzlich geeignet ist die Divergenz der austretenden elektromagnetischen Strahlung zu verringern.

Alternativ zu reflektierend beschichteten Seitewänden kann die reflektierende Optik 6 ein ein dielektrisches Material enthaltender Vollkörper sein. Das Material des Vollkörpers weist dabei beispielsweise einen Brechungsindex auf, so dass über die Lichteingangsöffnung 12 eingekoppelte elektromagnetische Strahlung durch Totalreflektion an seitlichen Grenzflächen des Vollkörpers zum umgebenden Medium reflektiert wird. Dabei ist es insbesondere auch möglich, dass das zweite optische Element 8 durch eine nach außen gewölbte Grenzfläche des Vollkörpers gebildet ist. Bei diesem Ausführungsbeispiel ist es insbesondere möglich, dass der Leuchtdiodenchip 1 mit dem dielektrischen Material umgossen ist.

## Patentansprüche

1. Leuchtdioden-Anordnung, aufweisend
- wenigstens einen Leuchtdiodenchip (1) mit einer Strahlungsauskoppelfläche (2), über die die im Leuchtdiodenchip (1) erzeugte elektromagnetische Strahlung (13) in einer Hauptabstrahlrichtung austritt;
- ein Gehäuse (5), das den Leuchtdiodenchip (1) seitlich umschließt sowie
- eine reflektive Optik (6), die der Strahlungsauskoppelfläche (2) in der Hauptabstrahlrichtung nachgeordnet ist, wobei
- der Leuchtdiodenchip (1) mit seiner der Strahlungsauskoppelfläche (2) gegenüberliegenden Oberfläche auf einen keramischen Kühlkörper (4) aufgebracht ist, wobei
- die reflektive Optik (6) eine Lichteingangsöffnung (12) aufweist, durch die ein Großteil der im Leuchtdiodenchip (1) erzeugten elektromagnetischen Strahlung (13) eintritt und die Lichteingangsöffnung (12) eine Fläche aufweist, die maximal doppelt so groß wie die Strahlungsauskoppelfläche (2) des Leuchtdiodenchips (1) ist,
- die Strahlungsauskoppelfläche (2) durch eine der Hauptflächen des Leuchtdiodenchips (1) gegeben ist, und wobei
- Seitenflächen des Leuchtdiodenchips quer zu den Hauptflächen verlaufen.

2. Leuchtdioden-Anordnung nach Anspruch 1,
bei der der Leuchtdiodenchip (1) ein Dünnfilmleuchtdiodenchip ist.

3. Leuchtdioden-Anordnung nach einem der Ansprüche 1 bis 2,
bei der der Leuchtdiodenchip (1) geeignet ist, Blitzlicht mit einer Beleuchtungsdauer von maximal 200 ms zu erzeugen.

4. Leuchtdioden-Anordnung nach einem der Ansprüche 1 bis 3,
bei der der Leuchtdiodenchip (1) geeignet ist, für wenigstens 5 Minuten im Dauerbetrieb zu leuchten.

5. Leuchtdioden-Anordnung nach einem der Ansprüche 1 bis 4,
bei der die reflektive Optik (6) geeignet ist, die Divergenz der vom Leuchtdiodenchip (1) abgegebenen elektromagnetischen Strahlung (13) zu reduzieren.

6. Leuchtdioden-Anordnung nach einem der Ansprüche 1 bis 5,
bei der die reflektive Optik (6) eine nicht abbildende Optik ist.

7. Leuchtdioden-Anordnung nach einem der Ansprüche 1 bis 6,
bei der die reflektive Optik (6) ein optischer Konzentrator ist, wobei die Lichteingangsöffnung (12) die eigentliche Lichtausgangsöffnung des Konzentrators ist.

8. Leuchtdioden-Anordnung nach Anspruch 7,
bei der die reflektive Optik (6) wenigstens teilweise nach Art wenigstens eines der folgenden optischen Elemente gebildet ist: CPC, CEC, CHC, TIR.

9. Leuchtdioden-Anordnung nach einem der Ansprüche 1 bis 8,
bei der die reflektive Optik (6) eine Lichtausgangsöffnung (14) aufweist, durch die die im Leuchtdiodenchip erzeugte elektromagnetische Strahlung (13) aus der reflektiven Optik (6) austritt und der Lichtausgangsöffnung (14) in der Hauptabstrahlrichtung ein Abdeckkörper (7) nachgeordnet ist.

10. Leuchtdioden-Anordnung nach Anspruch 9,
bei der der Abdeckkörper (7) ein optisches Element (8) enthält.

11. Leuchtdioden-Anordnung nach Anspruch 10,
bei der das optische Element (8) eine Lichtausgangsfläche aufweist, die nach Art einer asphärischen Linse gewölbt ist.

12. Leuchtdioden-Anordnung nach Anspruch 10,
bei der das optische Element (8) nach Art einer Fresnel-Linse gebildet ist.

13. Leuchtdioden-Anordnung nach einem der Ansprüche 9 bis 12,
bei der der Abdeckkörper (7) bei der Montage der Leuchtdiodenanordnung in ein Systemgehäuse als Führung und/oder Anschlag dient.

14. Leuchtdioden-Anordnung nach einem der vorherigen Ansprüche,
bei der dem Leuchtdiodenchip (1) in Hauptabstrahlrichtung ein Lumineszenz-Konversionsmaterial nachgeordnet ist, welches zumindest einen Teil der vom Leuchtdiodenchip (1) emittierten elektromagnetischen Strahlung wellenlängenkonvertiert.

15. Leuchtdioden-Anordnung nach Anspruch 14,
bei der das Lumineszenz-Konversionsmaterial als Schicht auf die Strahlungsauskoppelfläche (2) aufgebracht ist, wobei die Schichtdicke maximal 50 *µ*m beträgt.

16. Leuchtdioden-Anordnung nach Anspruch 14,
bei der ein Plättchen (11), das das Lumineszenz-Konversionsmaterial enthält, der Strahlungsauskoppelfläche (2) nachgeordnet ist, wobei die Dicke des Plättchens (11) maximal 200 *µ*m beträgt.

17. Leuchtdiode-Anordnung nach Anspruch 14,
bei der das optische Element (8) das Lumineszenz-Konversionsmaterial enthält.

18. Leuchtdioden-Anordnung nach einem der Ansprüche 1 bis 17,
bei der ein Öffnungswinkel eines aus der Leuchtdioden-Anordnung austretenden Lichtkegels maximal 35° beträgt.

19. Leuchtdioden-Anordnung nach einem der vorhergehenden Ansprüche,
bei der der Kühlkörper (4) Durchkontaktierungen aufweist.

20. Leuchtdioden-Anordnung nach einem der vorhergehenden Ansprüche,
bei der die dem Leuchtdiodenchip (1) abgewandten Oberfläche des Kühlkörpers (4) Kontaktflächen aufweist.

21. Leuchtdioden-Anordnung nach einem der vorhergehenden Ansprüche,
bei der der Kühlkörper (4) mit seiner dem Leuchtdiodenchip (1) abgewandten Oberfläche auf einen Träger (9) aufgebracht ist.

22. Leuchtdioden-Anordnung nach einem der vorhergehenden Ansprüche,
bei der am Träger (9) Kontaktfedern (10) befestigt sind, die wenigstens eines der folgenden Materialien enthalten: CuFeP, CuBe.

23. Leuchtdioden-Anordnung nach einem der vorhergehenden Ansprüche,
bei der zumindest Teile einer Kontaktfeder (10) zwischen Kühlkörper (4) und Träger (9) angeordnet sind, und die Kontaktfeder (10) in einem spitzen Winkel um den Träger (9) gebogen ist.

24. Leuchtdioden-Anordnung nach einem der vorherigen Ansprüche,
bei der das Gehäuse (5) auf dem Kühlkörper (4) befestigt ist.

25. Leuchtdioden-Anordnung nach einem der vorherigen Ansprüche,
bei der die äußeren Abmessungen der Leuchtdioden-Anordnung maximal 4x4x4 mm betragen.

26. Verwendung einer Leuchtdioden-Anordnung nach einem der vorangegangenen Ansprüche in einem der folgenden Geräte: Handy, Video-Kamera, Fotoapparat.

## Claims

1. Light-emitting diode arrangement, having:
- at least one light-emitting diode chip (1) comprising a radiation output surface (2), via which the electromagnetic radiation (13) generated in the light-emitting diode chip (1) exits in a main emission direction;
- a housing (5), which laterally surrounds the light-emitting diode chip (1), and
- a reflective optics (6), which is arranged downstream of the radiation output surface (2) in the main emission direction, wherein
- the light-emitting diode chip (1) is applied to a ceramic cooling body (4) with its surface opposite the radiation output surface (2), wherein
- the reflective optics (6) has a light entrance opening (12), through which a main part of the electromagnetic radiation generated within the light-emitting diode chip (1) enters and the light entrance opening (12) has an area, which is at most twice as large as the radiation output surface (2) of the light-emitting diode chip (1),
- the radiation output surface (2) is formed through one of the main faces of the light-emitting diode chip (1), and wherein
- side faces of the light-emitting diode chip (1) run traverse to the side faces.

2. Light-emitting diode arrangement according to claim 1, in which the light-emitting diode chip (1) is a thin-film light-emitting diode chip.

3. Light-emitting diode arrangement according to any of claims 1 to 2, in which the light-emitting diode chip (1) is suitable to generate flashing light with a duration of illumination of at most 200 ms.

4. Light-emitting diode arrangement according to any of claims 1 to 3, in which the light-emitting diode chip is suitable for lighting at least 5 minutes in continuous operation.

5. Light-emitting diode arrangement according to any of claims 1 to 4, in which the reflective optics (6) is suitable to reduce the divergence of the electromagnetic radiation (13) emitted by the light-emitting diode chip (1).

6. Light-emitting diode arrangement according to any of claims 1 to 5, in which the reflective optics (6) is a non-imaging optics.

7. Light-emitting diode arrangement according to any of claims 1 to 6, in which the reflective optics (6) is an optical concentrator, wherein the light entrance opening (12) is the actual light entrance opening of the concentrator.

8. Light-emitting diode arrangement according to claim 7, in which the reflective optics is at least partially formed in the manner of at least one of the following optical elements: CPC, CEC, CHC, TIR.

9. Light-emitting diode arrangement according to any of claims 1 to 8, in which the reflective optics (6) has a light output opening (14), through which the electromagnetic radiation (13) generated in the light-emitting diode chip exits from the reflective optics (6) and a cover body (7) is arranged downstream of the light output opening (14) in the main emission direction.

10. Light-emitting diode arrangement according to claim 9, in which the cover body (7) contains an optical element (8).

11. Light-emitting diode arrangement according to claim 10, in which the optical element (8) has a light output surface, which is curved in the manner of an aspherical lens.

12. Light-emitting diode arrangement according to claim 10, in which the optical element (8) is formed in the manner of a Fresnel lens.

13. Light-emitting diode arrangement according to any of claims 9 to 12, in which the cover body (7) serves as a guide and/or stop when mounting the light-emitting diode arrangement in a system housing.

14. Light-emitting diode arrangement according to any of the preceding claims, in which a luminescence conversion material is arranged downstream of the light-emitting diode chip (1) in the main emission direction, said luminescence conversion material converting the wavelength of at least some of the electromagnetic radiation emitted by the light-emitting diode chip (1).

15. Light-emitting diode arrangement according to claim 14, in which the luminescence conversion material is applied as a layer to the radiation output surface (2), wherein the layer thickness being at most 50 µm.

16. Light-emitting diode arrangement according to claim 14, in which a die (11) containing the luminescent conversion material is arranged downstream of the radiation output surface (2), the thickness of the die (11) being at most 200 µm.

17. Light-emitting diode arrangement according to claim 14, in which the optical element (8) contains the luminescence conversion material.

18. Light-emitting diode arrangement according to any of claims 1 to 17, at which an opening angle of a light cone emerging from the light-emitting diode arrangement is at most 35°.

19. Light-emitting diode arrangement according to any of the preceding claims, in which the cooling body (4) has vias.

20. Light-emitting diode arrangement according to any of the preceding claims, in which the surface of the cooling body (4) facing away from the light-emitting diode chip (1) has contact surfaces.

21. Light-emitting diode arrangement according to any of the preceding claims, in which the cooling body (4) is applied to a carrier (9) with its surface facing away from the light-emitting diode chip (1).

22. Light-emitting diode arrangement according to any of the preceding claims, in which contact springs (10) containing at least one of the following materials are attached to the carrier (9): CuFeP, CuBe.

23. Light-emitting diode arrangement according to any of the preceding claims, in which at least parts of a contact spring (10) are arranged between cooling body (4) and carrier (9), and the contact spring (10) is bent around the carrier (9) at an acute angle.

24. Light-emitting diode arrangement according to to any of the preceding claims, in which the housing (5) is attached on the cooling body (4).

25. Light-emitting diode arrangement according to any of the preceding claims, in which the external dimensions of the light-emitting diode arrangement are 4x4x4 mm at most.

26. Use of a light-emitting diode arrangement according to any of the preceding claims in any of the following device: cell phone, video camera, photo camera.

## Revendications

1. Réseau de diodes électroluminescentes comprenant
- au moins une puce de diode électroluminescente (1) ayant une surface de découplage de rayonnement (2) par laquelle le rayonnement électromagnétique (13) généré dans la puce de diode électroluminescente (1) sort dans une direction principale de rayonnement ;
- un boîtier (5) qui entoure la puce LED (1) sur le côté, ainsi que
- une optique réfléchissante (6) disposée en aval de la surface de découplage de rayonnement (2) dans la direction principale de rayonnement,
- la puce de diode électroluminescente (1) étant appliquée sur un dissipateur thermique en céramique (4) avec sa surface opposée à la surface de découplage de rayonnement (2),
- l'optique réfléchissante (6) présentant un orifice d'entrée de lumière (12) par lequel pénètre une grande partie du rayonnement électromagnétique (13) généré dans la puce de diode électroluminescente (1) et l'orifice d'entrée de lumière (12) présentant une surface au maximum deux fois plus grande que la surface de découplage de rayonnement (2) de la puce de diode électroluminescente (1),
- la surface de découplage de rayonnement (2) est donnée par l'une des surfaces principales de la puce de diode électroluminescente (1) et où
- les surfaces latérales de la puce de diode électroluminescente s'étendent transversalement par rapport aux surfaces principales.

2. Réseau de diodes électroluminescentes selon la revendication 1,
dans lequel la puce de diode électroluminescente (1) est une puce de diode électroluminescente à film mince.

3. Réseau de diodes électroluminescentes selon l'une des revendications 1 à 2,
dans lequel la puce de diode électroluminescente (1) est appropriée pour générer un flash d'une durée d'éclairage maximale de 200 ms.

4. Réseau de diodes électroluminescentes selon l'une des revendications 1 à 3,
dans lequel la puce de diode électroluminescente (1) est apte à rester allumée pendant au moins 5 minutes en fonctionnement continu.

5. Réseau de diodes électroluminescentes selon l'une des revendications 1 à 4,
dans lequel l'optique réfléchissante (6) convient pour réduire la divergence du rayonnement électromagnétique (13) émis par la puce de diode électroluminescente (1).

6. Réseau de diodes électroluminescentes selon l'une des revendications 1 à 5,
dans lequel l'optique réfléchissante (6) est une optique sans image.

7. Réseau de diodes électroluminescentes selon l'une des revendications 1 à 6,
dans lequel l'optique réfléchissante (6) est un concentrateur optique, l'orifice d'entrée de lumière (12) étant l'orifice de sortie de lumière réel du concentrateur.

8. Réseau de diodes électroluminescentes selon la revendication 7,
dans lequel l'optique réfléchissante (6) est au moins partiellement formée selon le type d'au moins l'un des éléments optiques suivants : CPC, CEC, CHC, TIR.

9. Réseau de diodes électroluminescentes selon l'une des revendications 1 à 8,
dans lequel l'optique réfléchissante (6) présente un orifice de sortie de lumière (14) à travers lequel le rayonnement électromagnétique (13) généré dans la puce de diode électroluminescente sort de l'optique réfléchissante (6) et un corps de couvercle (7) est disposé en aval de l'orifice de sortie de lumière (14) dans la direction principale de rayonnement.

10. Réseau de diodes électroluminescentes selon la revendication 9,
dans lequel le corps de couvercle (7) contient un élément optique (8).

11. Réseau de diodes électroluminescentes selon la revendication 10,
dans lequel l'élément optique (8) présente une surface de sortie de lumière bombée à la manière d'une lentille asphérique.

12. Réseau de diodes électroluminescentes selon la revendication 10,
dans lequel l'élément optique (8) est formé à la manière d'une lentille de Fresnel.

13. Réseau de diodes électroluminescentes selon l'une des revendications 9 à 12,
dans lequel le corps de couvercle (7) sert de guide et / ou d'arrêt lors du montage du réseau de diodes électroluminescentes dans un boîtier de système.

14. Réseau de diodes électroluminescentes selon l'une des revendications précédentes,
dans lequel un matériau de conversion de luminescence est disposé en aval de la puce de diode électroluminescente (1) dans la direction principale de rayonnement, ledit matériau convertissant au moins une partie du rayonnement électromagnétique émis par la puce de diode électroluminescente (1) en longueurs d'onde.

15. Réseau de diodes électroluminescentes selon la revendication 14,
dans lequel le matériau de conversion de luminescence est appliqué sous forme de couche sur la surface de découplage de rayonnement (2), l'épaisseur maximale de la couche étant de 50 µm.

16. Réseau de diodes électroluminescentes selon la revendication 14, dans lequel une plaquette (11) contenant le matériau de conversion de luminescence est disposée en aval de la surface de découplage de rayonnement (2), l'épaisseur maximale de la plaquette (11) étant de 200 µm.

17. Réseau de diodes électroluminescentes selon la revendication 14,
dans lequel l'élément optique (8) contient le matériau de conversion de luminescence.

18. Réseau de diodes électroluminescentes selon l'une des revendications 1 à 17,
dans lequel l'angle d'ouverture d'un cône lumineux sortant du réseau de diodes électroluminescentes est de 35° au maximum.

19. Réseau de diodes électroluminescentes selon l'une des revendications précédentes,
dans lequel le dissipateur thermique (4) présente des contacts traversants.

20. Réseau de diodes électroluminescentes selon l'une des revendications précédentes,
dans lequel la surface du dissipateur thermique (4) opposée à la puce de diode électroluminescente (1) présente des surfaces de contact.

21. Réseau de diodes électroluminescentes selon l'une des revendications précédentes,
dans lequel le dissipateur thermique (4) avec sa surface opposée à la puce de diode électroluminescente (1) est installé sur un support (9).

22. Réseau de diodes électroluminescentes selon l'une des revendications précédentes,
dans lequel des ressorts de contact (10) contenant au moins l'un des matériaux suivants sont fixés au support (9) : CuFeP, CuBe.

23. Réseau de diodes électroluminescentes selon l'une des revendications précédentes,
dans lequel au moins des parties d'un ressort de contact (10) sont disposées entre le dissipateur thermique (4) et le support (9), et le ressort de contact (10) est courbé à un angle aigu autour du support (9).

24. Réseau de diodes électroluminescentes selon l'une des revendications précédentes,
dans lequel le boîtier (5) est fixé sur le dissipateur thermique (4).

25. Réseau de diodes électroluminescentes selon l'une des revendications précédentes,
dans lequel les dimensions extérieures du réseau de diodes électroluminescentes sont au maximum de 4 x 4 x 4 mm.

26. Utilisation d'un réseau de diodes électroluminescentes selon l'une des revendications précédentes dans l'un des dispositifs suivants : téléphone portable, caméra vidéo, appareil-photo.
